(19) Europäisches Patentamt

European Patent Office

Office européen des brevets

(11) **EP 0 991 074 B1**

(12) **EUROPÄISCHE PATENTSCHRIFT**

| | |
|---|---|
| (45) Veröffentlichungstag und Bekanntmachung des Hinweises auf die Patenterteilung: **27.07.2005 Patentblatt 2005/30** | (51) Int Cl.⁷: $G11C\ 7/10$, $G11C\ 7/22$ |

(21) Anmeldenummer: **99119024.0**

(22) Anmeldetag: **29.09.1999**

(54) **Schaltung zur Erzeugung eines Ausgangssignals in Abhängigkeit von zwei Eingangssignalen**

A circuit for the generation of an output signal from two input signals

Un circuit pour la génération d'un signal de sortie en fonction de deux signaux d'entrée

(84) Benannte Vertragsstaaten:
**DE FR GB IE IT**

(30) Priorität: **30.09.1998 DE 19844936**

(43) Veröffentlichungstag der Anmeldung:
**05.04.2000 Patentblatt 2000/14**

(73) Patentinhaber: **Infineon Technologies AG**
**81669 München (DE)**

(72) Erfinder: **Johnson, Bret**
**81737 München (DE)**

(74) Vertreter: **Reinhard - Skuhra - Weise & Partner**
**Postfach 44 01 51**
**80750 München (DE)**

(56) Entgegenhaltungen:
**DE-A- 19 752 161**      **US-A- 4 110 842**

**Beschreibung**

Die vorliegende Erfindung betrifft eine Schaltung zur Erzeugung eines Ausgangssignals in Abhängigkeit von zwei Eingangssignalen, die als Teil einer Ansteuerung für einen Ausgangstreiber sicherstellt, daß Daten zu einem Zeitpunkt ausgegeben werden, ab dem sie als gültig angesehen werden.

Als Bestandteil integrierter Halbleiterschaltungen nehmen Ausgangstreiber verschiedener Art eine zentrale Funktion ein. Durch höhere Takt- und Datenraten in integrierten Halbleiterschaltungen steigen auch die Anforderungen hinsichtlich der Schaltgeschwindigkeit und einer zuverlässigen Spannungsversorgung. Die in Zusammenhang mit hohen Taktraten entstehenden hohen Stromimpulse an Ausgangstreibern und an der Spannungsversorgung, die in schwingfähigen Systemen zu Potentialschwankungen führen, können zum Teil Fehlfunktionen in anderen Schaltungsteilen eines Halbleiterspeichers verursachen. Schwingfähige Systeme entstehen z. B. durch Leitungsinduktivitäten von Zuleitungen, Bond-Drähten oder Leadframes in Verbindung mit Kapazitäten auf dem Chip.

Insbesondere können Probleme entstehen, wenn das Signal, das einen Ausgangstreiber freigibt, und ein am Ausgangstreiber anzulegendes Datum unterschiedliche Laufzeiten aufweisen. Dieses Problem ist vor allem bei getakteten Hochgeschwindigkeits-Speicherbausteinen präsent, bei denen der Speicherzugriff asynchron zum Takt, der den Ausgangstreiber freigibt, ausgelöst wird. Wenn der Ausgangstreiber zu früh freigegeben wird, besteht die Gefahr, daß das auszugebende Datum noch nicht gültig ist und seinen Zustand während des freigegebenen Zustands des Treibers ändert. In einem solchen Fall schaltet ein entsprechender Schalttransistor des Ausgangstreibers zweimal in unmittelbarer Folge, was bei hohen Taktraten von bereits einfachen Schaltvorgängen zu noch höheren Stromsteilheiten führt. Hinzu kommt, daß der Ausgangstreiber beim zweiten Schaltvorgang nicht aus dem hochohmigen Zustand schaltet, sondern mindestens ein Schalttransistor bereits leitend ist. Bei einer Zustandsänderung muß dieser möglichst schnell in den nicht leitenden Zustand versetzt werden, was zusätzliche Stromimpulse hervorruft, die den oben genannten Effekt verstärken. Die so entstehenden Störungen und Unregelmäßigkeiten resultieren in Potentialschwankungen an den Anschlüssen des Ausgangstreibers oder der Versorgungsspannung, die signifikant höher sind als bei einem normalen einfachen Schaltvorgang.

Bisher wurde versucht, die Stromsteilheiten, die durch Schaltvorgänge von Ausgangstreibern hervorgerufen werden, zu begrenzen, ebenso wie die Induktivitäten auf dem Chip in deren Größe zu reduzieren. Die technischen Möglichkeiten sind hier jedoch begrenzt. In früheren DRAM-Architekturen, insbesondere Fast-Page-Mode- und Extended-Data-Out-DRAMs mit festen Zugriffszyklen, wird ein Gültigkeitssignal generiert, das den Ausgangstreiber erst bei Vorliegen von gültigen Daten freigibt. So wird gewährleistet, daß nur ein einmaliger Schaltvorgang des Ausgangstreibers stattfindet. Dabei wird eine gewisse Speicherzugriffszeit vorausgesetzt, die ab der Auslösung des Datenzugriffs verstreicht und um die verzögert der Ausgangstreiber freigegeben wird. Bei höheren und variablen Frequenzen des Zugriffszyklus jedoch besteht die Gefahr, daß sich das Signal, das den Ausgangstreiber nach einem Datenzugriff sperrt, und die Speicherzugriffszeit zeitlich überlappen, was so zu fehlerhafter Funktion des Ausgangstreibers führt. Bei modernen DRAMs wie z. B. in DE 197 52 161 beschrieben, insbesondere SDRAMs und anderen Formen von getakteten DRAMs, ist eine zeitliche Überlappung der Speicherzugriffszeit und eines Taktsignals, das den Ausgangstreiber freigibt und wieder sperrt, in einem gewissen Bereich möglich. Eine einfache Steuerung des Datenzugriffs, die den Zugriffszyklus und damit die Freischaltung des Ausgangstreibers in Zeitpunkt und Dauer festlegt, ist daher nicht mehr angemessen, ohne daß die Gefahr von mehrfachen Schaltvorgängen während eines Zugriffszyklus besteht.

Die Aufgabe der vorliegenden Erfindung ist es, eine Schaltungsanordnung anzugeben, die dafür geeignet ist, einen Ausgangstreiber eines getakteten Halbleiterspeichers vom Typ DRAM im Zuge eines Speicherzugriffs anzusteuern, so daß ein zuverlässiger Betrieb bei variabler Taktfrequenz möglich ist.

Die Aufgabe wird gelöst durch eine Schaltung zur Erzeugung eines Ausgangssignals in Abhängigkeit von zwei Eingangssignalen nach den Merkmalen des Patentanspruchs 1. Danach wird der Ausgangstreiber bei einem zwischengespeicherten Gültigkeitssignal bei vergleichsweise kleinen und mittleren Taktfrequenzen durch eine Taktflanke und bei vergleichsweise hohen und sehr hohen Taktfrequenzen durch eine Flanke des Gültigkeitssignals freigeschalten.

Vorteilhafte Aus- und Weiterbildungen sind in Unteransprüchen gekennzeichnet. Danach werden eine ausreichende Pulsdauer des Freigabesignals für den Ausgangstreiber sichergestellt und eine Schaltung für eine ähnliche Ablaufsteuerung für ein zweites Freigabesignal sowie beispielhafte Ausführungen zu den möglichen Schaltungsvarianten angegeben.

Im folgenden wird die Erfindung anhand von den in der Zeichnung dargestellten Figuren näher erläutert.

Es zeigen:

Figur 1:          einen zeitlichen Ablauf von Steuersignalen eines integrierten Halbleiterspeichers vom Typ Fast-Page-Mode DRAM im Zuge eines Speicherzugriffs,

Figuren 2 bis 6:    einen zeitlichen Ablauf von Steuersignalen eines taktgesteuerten integrierten Halbleiterspeichers vom Typ SDRAM im Zuge eines Speicherzugriffs,

Figur 7:  einen beispielhaften Ausgangstreiber eines taktgesteuerten integrierten Halbleiterspeichers vom Typ SDRAM und eine Ansteuerung mit Hilfe der Steuersignale nach den Figuren 2 bis 6,

Figuren 8 und 9:  Blockschaltbilder einer Schaltung zur Erzeugung der Steuersignale nach den Figuren 2 bis 6,

Figuren 10 bis 14:  Schaltungstechnische Realisierung der Blockschaltbilder nach den Figuren 8 und 9.

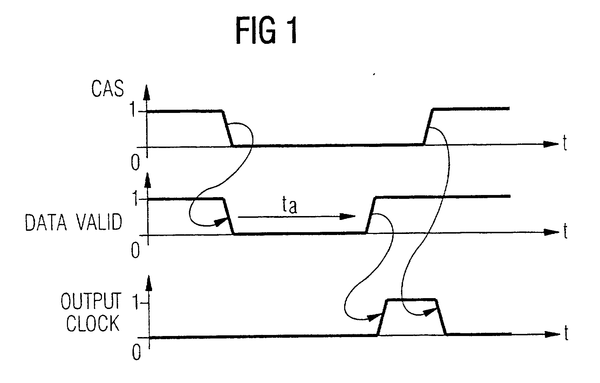

Figur 1 zeigt einen zeitlichen Ablauf von Steuersignalen eines integrierten Halbleiterspeichers vom Typ Fast-Page-Mode DRAM im Zuge eines Speicherzugriffs. Dazu wird die Adresse der betreffenden Speicherzelle von außen angelegt (nicht dargestellt). Durch ein Signal CAS wird die Adresse in den Speicher eingelesen und die entsprechende Speicherzelle angesprochen. Um zu verhindern, daß die Datenübertragung einsetzt, bevor die Daten am Eingang der Ausgangstreiberschaltung ihren endgültigen Zustand eingenommen haben, wird ein Gültigkeitssignal data valid erzeugt, das die Gültigkeit der auszugebenden Daten anzeigt. Es wird aktiv geschaltet, wenn die Daten gültig sind, und frühestens inaktiv, wenn der Zugriff abgeschlossen ist. Dadurch wird verhindert, das ein angelegtes Datum während der Freigabe des Ausgangstreibers den Zustand ändert und so gegebenenfalls einen zweifachen Schaltvorgang auslöst. Die Zeit, die vom Ansprechen der Speicherzelle mittels dem Signal CAS und dem Vorliegen von gültigen Daten verstreicht, ist die sogenannte Speicherzugriffszeit ta.

In Figur 1 ist dargestellt, wie nach dem Anlegen eines lowaktiven, d. h. aktiv im Zustand "log 0", Signals CAS nach Ablauf der Speicherzugriffszeit ta das Gültigkeitssignal data valid aktiv geschaltet wird, das wiederum ein Signal output clock zur Freigabe des Ausgangstreibers aktiviert. Die Signale data valid und output clock sind dabei high-aktiv, d.h. aktiv im Zustand "log 1". Die Freigabe des Ausgangstreibers wird mit dem Übergang des Signals CAS vom aktiven in den inaktiven Zustand beendet, das Signal output clock inaktiv. In diesem Anwendungsfall wiederholt sich das Signal CAS in regelmäßigen Abständen, der Zugriffszyklus weist also eine gleichmäßige Frequenz auf. Bei höheren oder variablen Frequenzen des Zugriffszyklus jedoch besteht die Gefahr, daß sich die Speicherzugriffszeit ta und der nächste Übergang des Signals CAS vom aktiven Zustand in den inaktiven Zustand zeitlich überlappen, so daß das Signal output clock nicht aktiviert wird, der Ausgangstreiber nicht freigeschalten wird. Für Anwendungen mit variablen Frequenzen des Speicherzugriffs ist das geschilderte Verfahren damit nur für einen eingeschränkten Frequenzbereich geeignet.

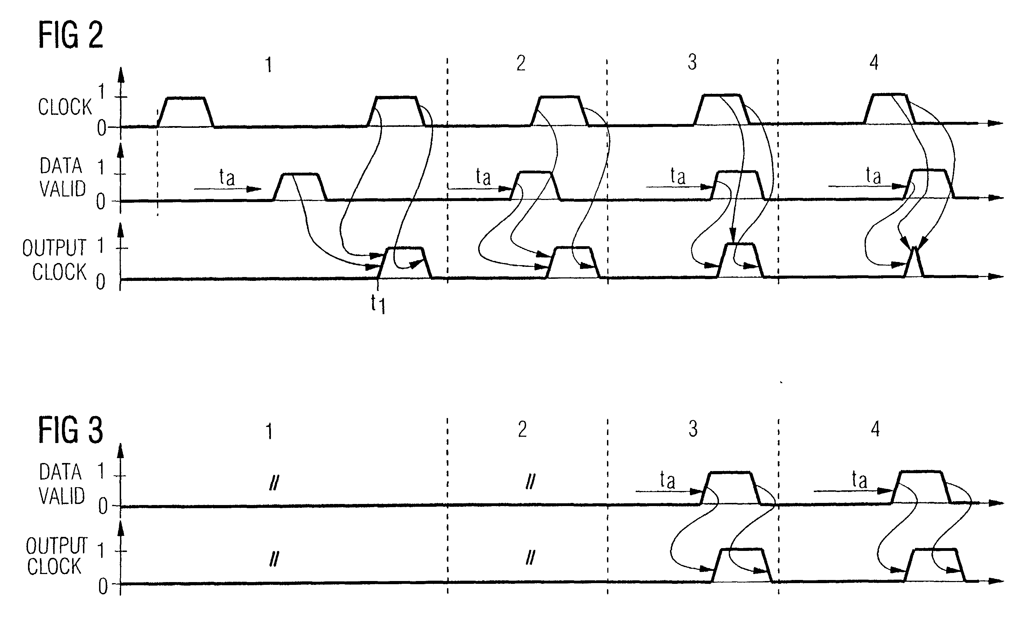

Die Figuren 2 bis 6 zeigen einen zeitlichen Ablauf von Steuersignalen eines taktgesteuerten integrierten Halbleiterspeichers vom Typ SDRAM im Zuge eines Speicherzugriffs. Das Taktsignal clock ist hierbei in der Frequenz veränderbar. Dargestellt sind mehrere Frequenzbereiche des Taktsignals clock und die unterschiedlichen Auswirkungen auf das Signal output clock zur Freigabe des Ausgangstreibers. Um veränderlichen Frequenzen beim Speicherzugriff Rechnung zu tragen, wird das Gültigkeitssignal data valid gepulst. Das Taktsignal clock ist high-aktiv. Ein Datenzugriff wird ähnlich dem Signal CAS aus Figur 1 durch einen Übergang des Taktsignals clock vom inaktiven in den aktiven Zustand ausgelöst. Das ebenfalls high-aktive Gültigkeitssignal data valid wird nach dem Verstreichen der Speicherzugriffszeit ta aktiv geschaltet.

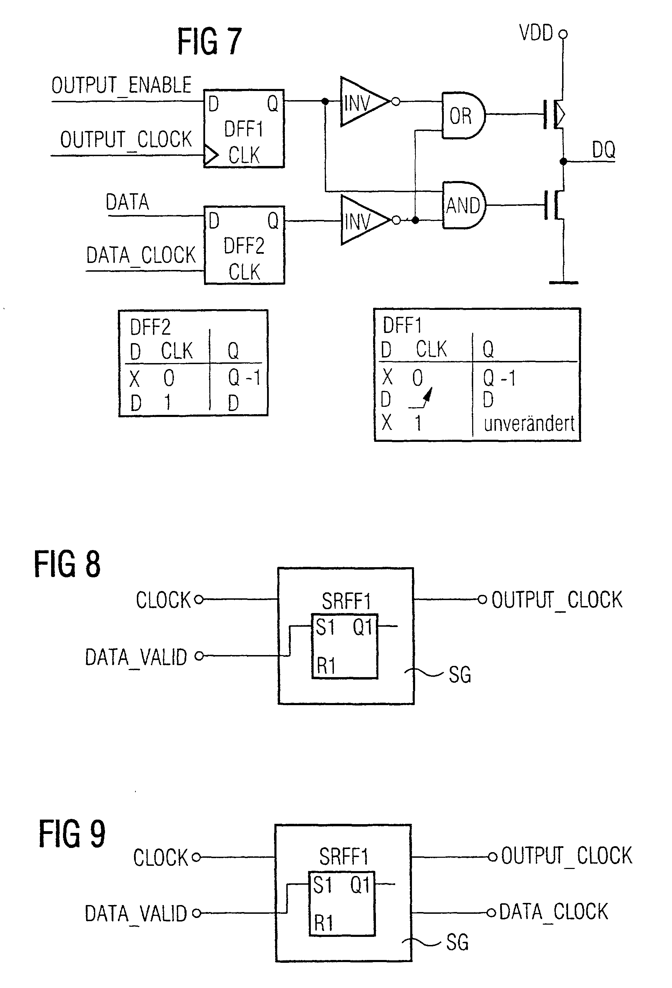

In den dargestellten Frequenzbereichen 1 und 2 nach Figur 2, die vergleichsweise kleine und mittlere Frequenzen des Taktsignals clock repräsentieren, wird das Gültigkeitssignal data valid zwischengespeichert. Bei Vorliegen eines aktiven zwischengespeicherten Gültigkeitssignals data valid schaltet der nächste Übergang des Taktsignals clock vom inaktiven in den aktiven Zustand das Signal output clock zur Freigabe des Ausgangstreibers (siehe auch Figur 7) zu einem ersten Zeitpunkt t1 in den aktiven Zustand (high-aktiv) . In den Frequenzbereichen 3 und 4 nach Figur 2, die vergleichsweise hohe und sehr hohe Frequenzen des Taktsignals clock repräsentieren, wird das Signal output clock nicht durch eine Flanke des Taktsignals clock aktiv geschaltet, sondern während des aktiven Taktsignals clock durch die Flanke des Gültigkeitssignals data valid vom inaktiven in den aktiven Zustand. Letztlich wird der erste Zeitpunkt t1 des Schaltvorgangs durch diejenige Flanke des Signals clock oder data valid bestimmt, die zeitlich zuletzt eintritt. Das Signal output clock wird inaktiv geschaltet bei einem unmittelbar auf den ersten Zeitpunkt t1 folgenden Übergang des Taktsignals clock vom aktiven in den inaktiven Zustand. Grundsätzlich ist die geschilderte Funktionalität der Ausgangstreiberschaltung und damit des Speicherzugriffs nur gewährleistet, wenn sich die aktiven Zustände der Signale clock und data valid zeitlich überlappen. Bei sehr hohen Frequenzen (Frequenzbereich 4) kann deshalb die Funktionalität des Ausgangstreibers gefährdet sein. Da sich die aktiven Zustände der Signale clock und data valid kaum noch überlappen, wird der Puls des Signals output clock zeitlich sehr kurz, was bedeuten kann, daß nachgeschaltete Bauelemente (vgl. auch Figur 7) diesen nicht mehr detektieren. D. h., in einem solchen Fall wird der Ausgangstreiber nicht freigegeben und bleibt im hochohmigen Zustand.

In der Darstellung nach der Figur 3 wird das Signal output clock nicht ausschließlich durch eine Flanke des Taktsignals clock inaktiv geschaltet, sondern schaltet vom aktiven Zustand in den inaktiven Zustand bei einem unmittelbar auf den ersten Zeitpunkt t1 folgenden Übergang des Taktsignals clock von dem aktiven in den inaktiven Zustand oder beim Übergang des Gültigkeitssignals data valid von dem aktiven Zustand in den inaktiven Zustand, je nachdem welcher Übergang zuletzt eintritt. So wird gewährleistet, daß die Pulsdauer des aktiven Signals output clock lange genug anhält, um eine Freigabe des Ausgangstreibers auszulösen.

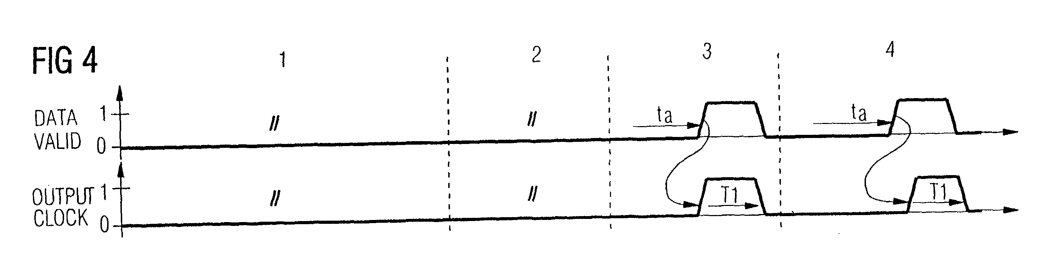

Dies kann auch in einer weiteren Variante sichergestellt werden, wie in den Frequenzbereichen 3 und 4 der Figur 4 gezeigt. Dort bleibt das Signal output clock während einer ersten festen Zeitdauer T1 im aktiven Zustand und geht anschließend in den inaktiven Zustand über. Hierbei sollte die erste feste Zeitdauer T1 mindestens solange sein, wie von den Bauteilen, die an den Anschluß für das Signal output clock angeschlossen sind, bei einem Zustandswechsel des Signals output clock für eine zuverlässige Signalerkennung benötigt wird (siehe auch Figur 7). Es ist hier zweckmäßig, eine Zeitdauer zu wählen, die der Zeit entspricht, in der das Taktsignal clock im aktiven Zustand ist, wie in Figur 4 dargestellt.

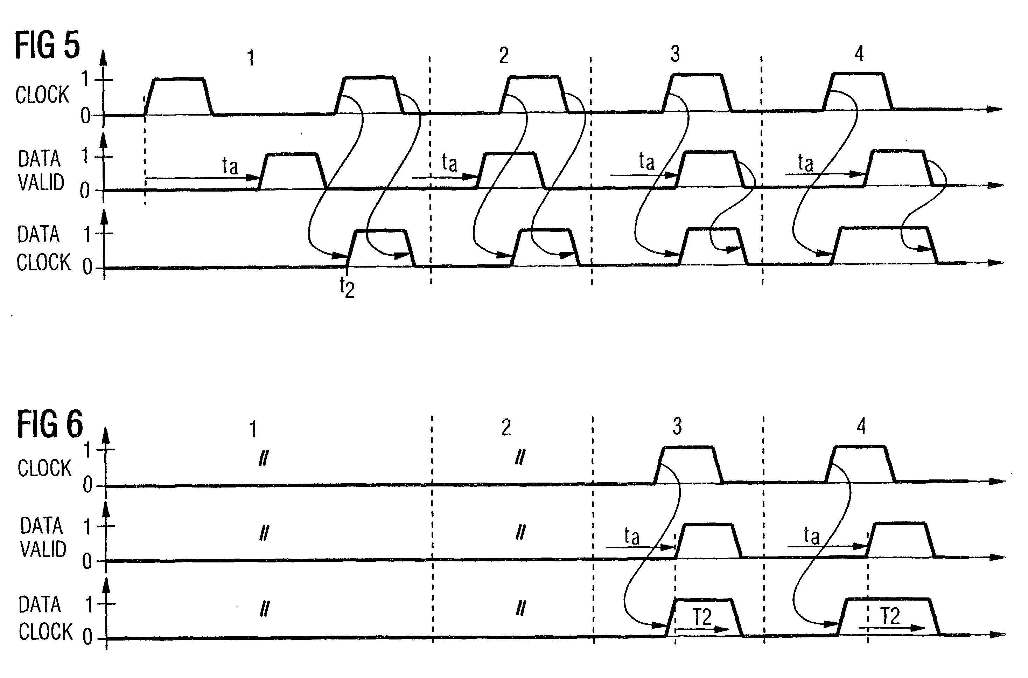

Ähnlich wie das Signal output clock zur Freigabe des Ausgangstreibers wird in den Figuren 5 und 6 das Signal data clock (high-aktiv) erzeugt, das zur Freigabe eines Datentreibers dient, der den Ausgangstreiber mit den auszugebenden Daten beaufschlagt (siehe auch Figur 7). Danach wird das Signal data clock zu einem zweiten Zeitpunkt t2 von dem inaktiven in den aktiven Zustand geschaltet bei einem Übergang des Taktsignals clock von dem inaktiven Zustand in den aktiven Zustand. Es hier nicht notwendig, das Signal data clock erst dann schalten zu lassen, wenn das Signal data valid aktiv ist. Gesteuert durch das Signal output clock ist der Ausgangstreiber vor dem aktiven Signal data valid nicht freigegeben und somit im hochohmigen Zustand, wodurch Änderungen am Dateneingang des Ausgangstreibers ohne Auswirkungen bleiben. Somit ist eine Vereinfachung des Schaltungsaufbaus zu erzielen.

Nach Figur 5 wird das Signal data clock vom aktiven Zustand in den inaktiven Zustand geschaltet bei einem unmittelbar auf den zweiten Zeitpunkt t2 folgenden Übergang des Taktsignals clock von dem aktiven in den inaktiven Zustand oder beim Übergang des Gültigkeitssignals data valid von dem aktiven Zustand in den inaktiven Zustand, je nach dem, welcher Übergang zeitlich zuletzt eintritt. Ebenso wie beim Signal output clock wird hier beabsichtigt, die Funktionalität der Treiberschaltung durch eine angemessene Pulsdauer des Signals data clock zu gewährleisten.

Eine andere Möglichkeit hierzu ist in Figur 6 dargestellt, wonach das Signal data clock während einer zweiten festen Zeitdauer T2 im aktiven Zustand bleibt und anschließend in den inaktiven Zustand übergeht. Auch hierbei sollte die zweite feste Zeitdauer T2 vom Zeitpunkt aus gerechnet, ab dem das Gültigkeitssignal data valid in den aktiven Zustand übergeht, mindestens solange sein, wie von den Bauteilen, die an den Anschluß für das Signal data clock angeschlossen sind, bei einem Zustandswechsel des Signals data clock für eine zuverlässige Signalerkennung benötigt wird. Es ist hier zweckmäßig, eine Zeitdauer zu wählen, die der Zeit entspricht, in der das Taktsignal clock im aktiven Zustand ist, wie in Figur 6 dargestellt.

In Figur 7 ist ein beispielhafter Ausgangstreiber eines taktgesteuerten integrierten Halbleiterspeichers vom Typ SDRAM mit einer beispielhaften Ansteuerung mit Hilfe der Steuersignale output clock und data clock nach den Figuren 2 bis 6 dargestellt. Zusätzlich zu den Eingangssignalen output clock und data clock sind das Signal output enable und das Signal data als Eingangssignale vorhanden. Das Signal output enable wird als übergeordnetes Freigabesignal der Ansteuerung vom Controller des Speichers zur Verfügung gestellt. Das Signal data enthält die zu lesenden Daten der angesteuerten Speicherzelle. Abhängig von den erwähnten Eingangssignalen wird ein Ausgangssignal DQ des Ausgangstreibers erzeugt, das den zu lesenden Daten der angesteuerten Speicherzelle entspricht. Von einer näheren Betrachtung der Schaltung wird hier aus Platzgründen jedoch abgesehen.

In Figur 8 ist ein Blockschaltbild einer Schaltung SG dargestellt, das ein Ausgangssignal in Abhängigkeit von zwei Eingangssignalen erzeugt. Das Ausgangssignal output clock nimmt dabei einen Verlauf an, wie in den Figuren 2 bis 4 dargestellt. Die Schaltung SG weist neben dem Anschluß für das Ausgangssignal output clock noch zwei Anschlüsse für zwei Eingangssignale clock und data valid auf, die jeweils aktive und inaktive Zustände aufweisen, und deren Verläufe ebenfalls in den Figuren 2 bis 4 dargestellt sind. Aktiv bedeutet hier, wie auch in den folgenden Ausführungen, den Zustand "log 1", inaktiv den Zustand "log 0". Der Anschluß für das zweite Eingangssignal data valid der Schaltung SG ist mit einem ersten Eingang S1 einer ersten Speichereinrichtung SRFF1 verbunden. Die erste Speichereinrichtung SRFF1 weist ihrerseits einen Anschluß für ein Ausgangssignal Q1 auf, das aktive und inaktive Zustände einnimmt. Die erste Speichereinrichtung SRFF1 ist derart beschaffen, daß das Ausgangssignal Q1 der ersten Speichereinrichtung SRFF1 einen aktiven Zustand aufweist, sobald am ersten Eingang S1 der ersten Speichereinrichtung SRFF1 ein aktives Signal anliegt.

In Figur 9 ist ein Blockschaltbild einer Schaltung SG dargestellt, die ein weiteres Ausgangssignal erzeugt. Die Schaltung ist ansonsten im Vergleich zu der Schaltung SG nach Figur 8 unverändert. Das weitere Ausgangssignal data clock nimmt dabei einen Verlauf an, wie in den Figuren 5 und 6 dargestellt.

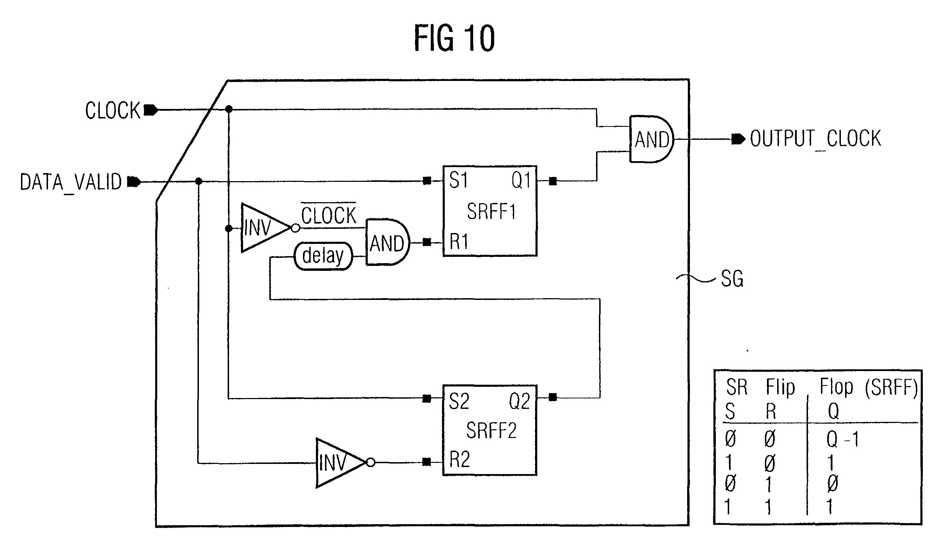

Die Figuren 10 bis 14 zeigen beispielhafte schaltungstechnische Realisierungen der Blockschaltbilder nach den Figuren 8 und 9.

Figur 10 zeigt aufbauend auf der Struktur des Blockschaltbildes nach Figur 8 eine Schaltung zur Erzeugung eines Ausgangssignals output clock mit einem Signalverlauf nach Figur 2. Die Schaltung SG weist eine zweite Speichereinrichtung SRFF2 auf, deren erster Eingang S2 mit dem ersten Eingangssignal clock der Schaltung SG und deren zweiter Eingang R2 über einen Inverter mit dem zweiten Eingangssignal data valid der Schaltung SG verbunden ist.

Die zweite Speichereinrichtung SRFF2 weist ihrerseits einen Anschluß für ein Ausgangssignal Q2 auf, das aktive und inaktive Zustände einnimmt. Das Ausgangssignal Q2 der zweiten Speichereinrichtung SRFF2 wird zeitlich verzögert und mit dem invertierten ersten Eingangssignal $\overline{clock}$ der Schaltung SG logisch UND-verknüpft an einen zweiten Anschluß R1 der ersten Speichereinrichtung SRFF1 geschaltet. Das Ausgangssignal Q1 der ersten Speichereinrichtung SRFF1 wird mit dem ersten Eingangssignal clock der Schaltung SG logisch UND-verknüpft, woraus sich das Ausgangssignal output clock der Schaltung SG ergibt.

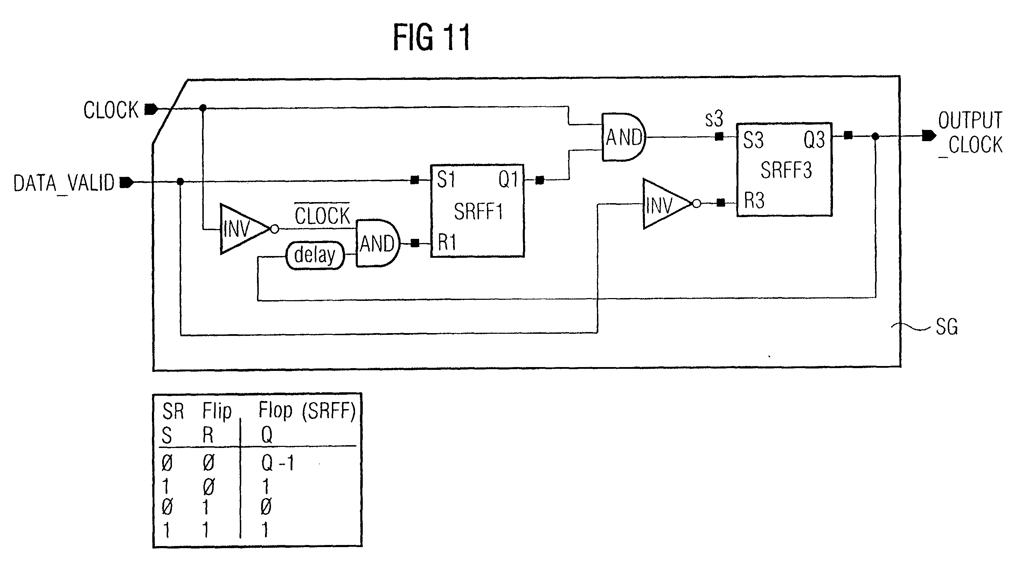

Figur 11 zeigt aufbauend auf der Struktur des Blockschaltbildes nach Figur 8 eine Schaltung zur Erzeugung eines Ausgangssignals output clock mit einem Signalverlauf nach Figur 3. Die Schaltung SG weist eine dritte Speichereinrichtung SRFF3 auf, deren erster Eingang S3 mit einem Signal s3 verbunden ist, das sich aus einer logischen UND-Verknüpfung des ersten Eingangssignals clock der Schaltung SG und des Ausgangssignals Q1 der ersten Speichereinrichtung SRFF1 ergibt, und deren zweiter Eingang R3 über einen Inverter mit dem zweiten Eingangssignal data valid der Schaltung SG verbunden ist. Die dritte Speichereinrichtung SRFF3 weist ihrerseits einen Anschluß für ein Ausgangssignal Q3 auf, das aktive und inaktive Zustände einnimmt und das Ausgangssignal output clock der Schaltung SG bildet. Das Ausgangssignal Q3 der dritten Speichereinrichtung SRFF3 wird zeitlich verzögert und mit dem invertierten ersten Eingangssignal $\overline{clock}$ der Schaltung SG logisch UND-verknüpft an einen zweiten Eingang R1 der ersten Speichereinrichtung SRFF1 geschaltet.

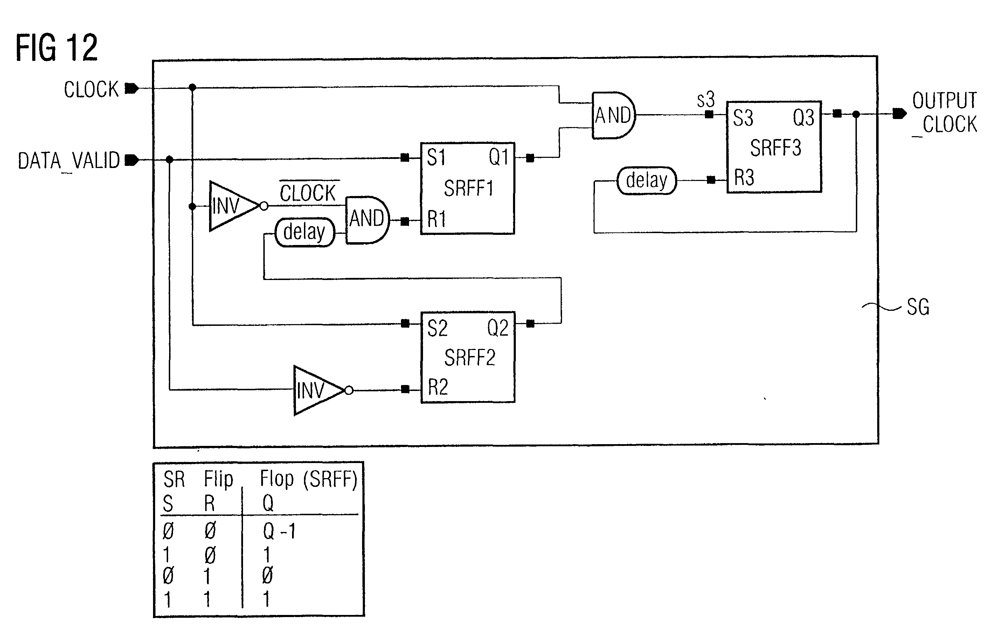

Figur 12 zeigt aufbauend auf der Struktur des Blockschaltbildes nach Figur 8 eine Schaltung zur Erzeugung eines Ausgangssignals output clock mit einem Signalverlauf nach Figur 4. Die Schaltung SG weist eine zweite Speichereinrichtung SRFF2 auf, deren erster Eingang S2 mit dem ersten Eingangssignal clock der Schaltung SG und deren zweiter Eingang R2 über einen Inverter mit dem zweiten Eingangssignal data valid der Schaltung SG verbunden ist. Die zweite Speichereinrichtung SRFF2 weist ihrerseits einen Anschluß für ein Ausgangssignal Q2 auf, das aktive und inaktive Zustände einnimmt. Das Ausgangssignal Q2 der zweiten Speichereinrichtung SRFF2 wird zeitlich verzögert und mit dem invertierten ersten Eingangssignal $\overline{clock}$ der Schaltung SG logisch UND-verknüpft an einen zweiten Anschluß R1 der ersten Speichereinrichtung SRFF1 geschaltet. Das Ausgangssignal Q1 der ersten Speichereinrichtung SRFF1 wird mit dem ersten Eingangssignal clock der Schaltung SG logisch UND-verknüpft. Die Schaltung SG weist eine dritte Speichereinrichtung SRFF3 auf, deren erster Eingang S3 mit einem Signal s3 verbunden ist, das sich aus der logischen Verknüpfung des ersten Eingangssignals clock der Schaltung SG und des Ausgangssignals Q1 der ersten Speichereinrichtung SRFF1 ergibt. Die dritte Speichereinrichtung SRFF3 weist ihrerseits einen Anschluß für ein Ausgangssignal Q3 auf, das aktive und inaktive Zustände einnimmt und das Ausgangssignal output clock der Schaltung SG bildet. Das Ausgangssignal Q3 der dritten Speichereinrichtung SRFF3 wird zeitlich verzögert an einen zweiten Eingang R3 der dritten Speichereinrichtung SRFF3 geschaltet.

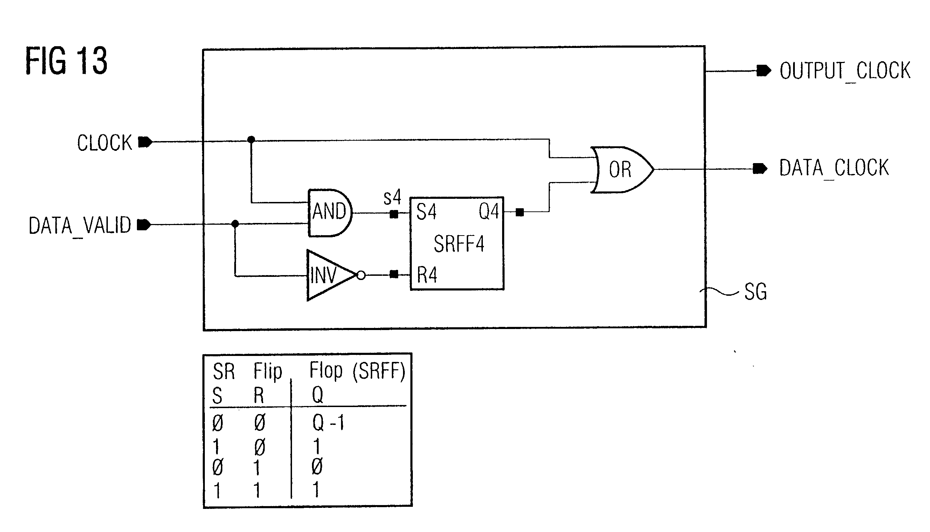

Figur 13 zeigt aufbauend auf der Struktur des Blockschaltbildes nach Figur 9 eine Schaltung zur Erzeugung eines weiteren Ausgangssignals data clock mit einem Signalverlauf nach Figur 5. Die Schaltung SG weist eine vierte Speichereinrichtung SRFF4 auf, deren erster Eingang S4 mit einem Signal s4 verbunden ist, das sich aus einer logischen UND-Verknüpfung des ersten Eingangssignals clock der Schaltung SG und des zweiten Eingangssignals data valid der Schaltung SG ergibt, und deren zweiter Eingang R4 über einen Inverter mit dem zweiten Eingangssignal data valid der Schaltung SG verbunden ist. Die vierte Speichereinrichtung SRFF4 weist ihrerseits einen Anschluß für ein Ausgangssignal Q4 auf, das aktive und inaktive Zustände einnimmt. Das weitere Ausgangssignal data clock der Schaltung SG ergibt sich aus einer logischen ODER-Verknüpfung des ersten Eingangssignals clock der Schaltung SG mit dem Ausgangssignal Q4 der vierten Speichereinrichtung SRFF4.

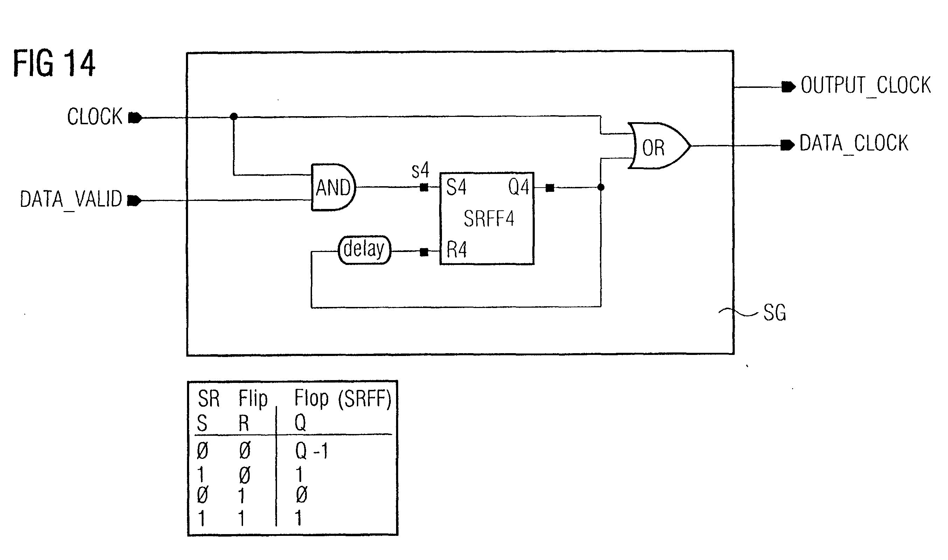

Figur 14 zeigt aufbauend auf der Struktur des Blockschaltbildes nach Figur 9 eine Schaltung zur Erzeugung eines weiteren Ausgangssignals data clock mit einem Signalverlauf nach Figur 6. Die Schaltung SG weist eine vierte Speichereinrichtung SRFF4 auf, deren erster Eingang S4 mit einem Signal s4 verbunden ist, das sich aus einer logischen UND-Verknüpfung des ersten Eingangssignals clock der Schaltung SG und des zweiten Eingangssignals data valid der Schaltung SG ergibt. Die vierte Speichereinrichtung SRFF4 weist ihrerseits einen Anschluß für ein Ausgangssignal Q4 auf, das aktive und inaktive Zustände einnimmt. Ein zweiter Eingang R4 der vierten Speichereinrichtung SRFF4 wird mit dem zeitlich verzögerten Ausgangssignal Q4 der vierten Speichereinrichtung SRFF4 verbunden. Das weitere Ausgangssignal data clock der Schaltung SG ergibt sich aus einer logischen ODER-Verknüpfung des ersten Eingangssignals clock der Schaltung SG mit dem Ausgangssignal Q4 der vierten Speichereinrichtung SRFF4.

In allen Schaltungen der Figuren 8-14 werden beispielhaft bistabile RS-Kippstufen (RS-Flipflops) als Speichereinrichtungen verwendet.

**Patentansprüche**

1. Schaltung zur Erzeugung eines Ausgangssignals in Abhängigkeit von zwei Eingangssignalen mit folgenden Merkmalen:

- die Schaltung (SG) weist zwei Anschlüsse für zwei Eingangssignale (clock, data valid), die jeweils aktive und inaktive Zustände aufweisen, und ein daraus abgeleitetes Ausgangssignal (output clock) mit aktiven und inaktiven Zuständen auf,
- die Schaltung (SG) weist einen Anschluß für ein weiteres Ausgangssignal (data clock) auf, das aktive und inaktive Zustände einnimmt,
- der Anschluß für das zweite Eingangssignal (data valid) der Schaltung (SG) ist mit einem ersten Eingang (S1) einer ersten Speichereinrichtung (SRFF1) verbunden,
- die erste Speichereinrichtung (SRFF1) weist ihrerseits einen Anschluß für ein Ausgangssignal (Q1) auf, das aktive und inaktive Zustände einnimmt,
- die erste Speichereinrichtung (SRFF1) ist derart beschaffen, daß das Ausgangssignal (Q1) der ersten Speichereinrichtung (SRFF1) einen aktiven Zustand aufweist, sobald am ersten Eingang (S1) der ersten Speichereinrichtung (SRFF1) ein aktives Signal anliegt;
- die Schaltung (SG) ist so ausgeführt, daß bei einem aktiven Ausgangssignal (Q1) der ersten Speichereinrichtung (SRFF1) das Ausgangssignal (output clock) der Schaltung (SG) zu einem ersten Zeitpunkt (t1) von dem inaktiven in den aktiven Zustand geschaltet wird entweder bei einem Übergang des ersten Eingangssignals (clock) der Schaltung (SG) von dem inaktiven Zustand in den aktiven Zustand oder während des aktiven ersten Eingangssignals (clock) der Schaltung (SG) bei einem Übergang des zweiten Eingangssignals (data valid) der Schaltung (SG) von dem inaktiven Zustand in den aktiven Zustand, je nach dem, welcher Übergang zeitlich zuletzt eintritt,
- die Schaltung (SG) ist so ausgeführt, daß das weitere Ausgangssignal (data clock) der Schaltung (SG) zu einem zweiten Zeitpunkt (t2) von dem inaktiven in den aktiven Zustand geschaltet wird bei einem Übergang des ersten Eingangssignals (clock) der Schaltung (SG) von dem inaktiven Zustand in den aktiven Zustand.

2. Schaltung zur Erzeugung eines Ausgangssignals nach Anspruch 1, **gekennzeichnet dadurch, daß** das Ausgangssignal (output clock) der Schaltung (SG) vom aktiven Zustand in den inaktiven Zustand geschaltet wird bei einem unmittelbar auf den ersten Zeitpunkt (t1) folgenden Übergang des ersten Eingangssignals (clock) der Schaltung (SG) von dem aktiven in den inaktiven Zustand.

3. Schaltung zur Erzeugung eines Ausgangssignals nach Anspruch 1, **gekennzeichnet dadurch, daß** das Ausgangssignal (output clock) der Schaltung (SG) vom aktiven Zustand in den inaktiven Zustand geschaltet wird bei einem unmittelbar auf den ersten Zeitpunkt (t1) folgenden Übergang des ersten Eingangssignals (clock) der Schaltung (SG) von dem aktiven in den inaktiven Zustand oder beim Übergang des zweiten Eingangssignals (data valid) der Schaltung (SG) von dem aktiven Zustand in den inaktiven Zustand, je nach dem, welcher Übergang zeitlich zuletzt eintritt.

4. Schaltung zur Erzeugung eines Ausgangssignals nach Anspruch 1, **gekennzeichnet dadurch, daß** das Ausgangssignal (output clock) der Schaltung (SG) während einer ersten festen Zeitdauer (T1) im aktiven Zustand bleibt und anschließend in den inaktiven Zustand übergeht.

5. Schaltung zur Steuerung eines Datentreibers nach Anspruch 4, **gekennzeichnet dadurch, daß** die erste feste Zeitdauer (T1) mindestens so lange ist, wie von den Bauteilen, die an den Anschluß für das Ausgangssignal (output clock) der Schaltung (SG) angeschlossen sind, bei einem Zustandswechsel des Ausgangssignals (output clock) der Schaltung (SG) für eine zuverlässige Signalerkennung benötigt wird.

6. Schaltung zur Erzeugung eines Ausgangssignals nach einem der vorhergehenden Ansprüche, **gekennzeichnet dadurch, daß** das weitere Ausgangssignal (data clock) der Schaltung (SG) vom aktiven Zustand in den inaktiven Zustand geschaltet wird bei einem unmittelbar auf den zweiten Zeitpunkt (t2) folgenden Übergang des ersten Eingangssignals (clock) der Schaltung (SG) von dem aktiven in den inaktiven Zustand oder beim Übergang des zweiten Eingangssignals (data valid) der Schaltung (SG) von dem aktiven Zustand in den inaktiven Zustand, je nach dem, welcher Übergang zeitlich zuletzt eintritt.

7. Schaltung zur Erzeugung eines Ausgangssignals nach einem der Ansprüche 1 bis 5, **gekennzeichnet dadurch, daß** das weitere Ausgangssignal (data clock) der Schaltung (SG) während einer zweiten festen Zeitdauer (T2) im aktiven Zustand bleibt und anschließend in den inaktiven Zustand übergeht.

8. Schaltung zur Erzeugung eines Ausgangssignals nach Anspruch 7, **gekennzeichnet dadurch, daß** die zweite feste Zeitdauer (T2) vom Zeitpunkt aus gerechnet, ab dem das zweite Eingangssignal (data valid) der Schaltung (SG) in den aktiven Zustand übergeht, mindestens so lange ist, wie von den Bauteilen, die an den Anschluß für das weitere Ausgangssignal (data clock) der Schaltung (SG) angeschlossen sind, bei einem Zustandswechsel des weiteren Ausgangssignals (data clock) der Schaltung (SG) für eine zuverlässige Signalerkennung benötigt wird.

9. Schaltung zur Erzeugung eines Ausgangssignals nach Anspruch 2, **gekennzeichnet durch** folgende Merkmale:

   - die Schaltung (SG) weist eine zweite Speichereinrichtung (SRFF2) auf, deren erster Eingang (S2) mit dem ersten Eingangssignal (clock) der Schaltung (SG) und deren zweiter Eingang (R2) über einen Inverter mit dem zweiten Eingangssignal (data valid) der Schaltung (SG) verbunden ist,
   - die zweite Speichereinrichtung (SRFF2) weist ihrerseits einen Anschluß für ein Ausgangssignal (Q2) auf, das aktive und inaktive Zustände einnimmt,
   - das Ausgangssignal (Q2) der zweiten Speichereinrichtung (SRFF2) wird zeitlich verzögert und mit dem invertierten ersten Eingangssignal ($\overline{clock}$) der Schaltung (SG) logisch verknüpft an einen zweiten Anschluß (R1) der ersten Speichereinrichtung (SRFF1) geschaltet,
   - das Ausgangssignal (Q1) der ersten Speichereinrichtung (SRFF1) wird mit dem ersten Eingangssignal (clock) der Schaltung (SG) logisch verknüpft, woraus sich das Ausgangssignal (output clock) der Schaltung (SG) ergibt.

10. Schaltung zur Erzeugung eines Ausgangssignals nach Anspruch 3, **gekennzeichnet durch** folgende Merkmale:

    - die Schaltung (SG) weist eine dritte Speichereinrichtung (SRFF3) auf, deren erster Eingang (S3) mit einem Signal (s3) verbunden ist, das sich aus einer logischen Verknüpfung des ersten Eingangssignals (clock) der Schaltung (SG) und des Ausgangssignals (Q1) der ersten Speichereinrichtung (SRFF1) ergibt, und deren zweiter Eingang (R3) über einen Inverter mit dem zweiten Eingangssignal (data valid) der Schaltung (SG) verbunden ist,
    - die dritte Speichereinrichtung (SRFF3) weist ihrerseits einen Anschluß für ein Ausgangssignal (Q3) auf, das aktive und inaktive Zustände einnimmt und das Ausgangssignal (output clock) der Schaltung (SG) bildet,
    - das Ausgangssignal (Q3) der dritten Speichereinrichtung (SRFF3) wird zeitlich verzögert und mit dem invertierten ersten Eingangssignal ($\overline{clock}$) der Schaltung (SG) logisch verknüpft an einen zweiten Eingang (R1) der ersten Speichereinrichtung (SRFF1) geschaltet.

11. Schaltung zur Erzeugung eines Ausgangssignals nach Anspruch 4, **gekennzeichnet durch** folgende Merkmale:

    - die Schaltung (SG) weist eine zweite Speichereinrichtung (SRFF2) auf, deren erster Eingang (S2) mit dem ersten Eingangssignal (clock) der Schaltung (SG) und deren zweiter Eingang (R2) über einen Inverter mit dem zweiten Eingangssignal (data valid) der Schaltung (SG) verbunden ist,
    - die zweite Speichereinrichtung (SRFF2) weist ihrerseits einen Anschluß für ein Ausgangssignal (Q2) auf, das aktive und inaktive Zustände einnimmt,
    - das Ausgangssignal (Q2) der zweiten Speichereinrichtung (SRFF2) wird zeitlich verzögert und mit dem invertierten ersten Eingangssignal ($\overline{clock}$) der Schaltung (SG) logisch verknüpft an einen zweiten Anschluß (R1) der ersten Speichereinrichtung (SRFF1) geschaltet,
    - das Ausgangssignal (Q1) der ersten Speichereinrichtung (SRFF1) wird mit dem ersten Eingangssignal (clock) der Schaltung (SG) logisch verknüpft,
    - die Schaltung (SG) weist eine dritte Speichereinrichtung (SRFF3) auf, deren erster Eingang (S3) mit einem Signal (s3) verbunden ist, das sich aus der logischen Verknüpfung des ersten Eingangssignals (clock) der Schaltung (SG) und des Ausgangssignals (Q1) der ersten Speichereinrichtung (SRFF1) ergibt,
    - die dritte Speichereinrichtung (SRFF3) weist ihrerseits einen Anschluß für ein Ausgangssignal (Q3) auf, das aktive und inaktive Zustände einnimmt und das Ausgangssignal (output clock) der Schaltung (SG) bildet,
    - das Ausgangssignal (Q3) der dritten Speichereinrichtung (SRFF3) wird zeitlich verzögert an einen zweiten Eingang (R3) der dritten Speichereinrichtung (SRFF3) geschaltet.

12. Schaltung zur Erzeugung eines Ausgangssignals nach Anspruch 6, **gekennzeichnet durch** folgende Merkmale:

    - die Schaltung (SG) weist eine vierte Speichereinrichtung (SRFF4) auf, deren erster Eingang (S4) mit einem Signal (s4) verbunden ist, das sich aus einer logischen Verknüpfung des ersten Eingangssignals (clock) der Schaltung (SG) und des zweiten Eingangssignals (data valid) der Schaltung (SG) ergibt, und deren zweiter Eingang (R4) über einen Inverter mit dem zweiten Eingangssignal (data valid) der Schaltung (SG) verbunden ist,
-   die vierte Speichereinrichtung (SRFF4) weist ihrerseits einen Anschluß für ein Ausgangssignal (Q4) auf, das aktive und inaktive Zustände einnimmt,
-   das weitere Ausgangssignal (data clock) der Schaltung (SG) ergibt sich aus einer logischen Verknüpfung des ersten Eingangssignals (clock) der Schaltung (SG) mit dem Ausgangssignal (Q4) der vierten Speichereinrichtung (SRFF4).

13.  Schaltung zur Erzeugung eines Ausgangssignals nach Anspruch 7, **gekennzeichnet durch** folgende Merkmale:

-   die Schaltung (SG) weist eine vierte Speichereinrichtung (SRFF4) auf, deren erster Eingang (S4) mit einem Signal (s4) verbunden ist, das sich aus einer logischen Verknüpfung des ersten Eingangssignals (clock) der Schaltung (SG) und des zweiten Eingangssignals (data valid) der Schaltung (SG) ergibt,
-   die vierte Speichereinrichtung (SRFF4) weist ihrerseits einen Anschluß für ein Ausgangssignal (Q4) auf, das aktive und inaktive Zustände einnimmt,
-   ein zweiter Eingang (R4) der vierten Speichereinrichtung (SRFF4) wird mit dem zeitlich verzögerten Ausgangssignal (Q4) der vierten Speichereinrichtung (SRFF4) verbunden,
-   das weitere Ausgangssignal (data clock) der Schaltung (SG) ergibt sich aus einer logischen Verknüpfung des ersten Eingangssignals (clock) der Schaltung (SG) mit dem Ausgangssignal (Q4) der vierten Speichereinrichtung (SRFF4).

**Claims**

1.  Circuit for production of an output signal as a function of two input signals, having the following features:

-   the circuit (SG) has two connections for two input signals (clock, data valid), which each have active and inactive states, and an output signal (output lock), which is derived from them, with active and inactive states,
-   the circuit (SG) has a connection for a further output signal (data clock) which assumes active and inactive states,
-   the connection for the second input signal (data valid) of the circuit (SG) is connected to a first input (S1) of a first memory device (SRFF1),
-   the first memory device (SRFF1) itself has a connection for an output signal (Q1) which assumes active and inactive states,
-   the first memory device (SRFF1) is designed such that the output signal (Q1) from the first memory device (SRFF1) is in an active state as soon as an active signal is applied to the first input (S1) of the first memory device (SRFF1);
-   the circuit (SG) is designed such that, when the output signal (Q1) from the first memory device (SRFF1) is active, the output signal (output clock) from the circuit (SG) is switched from the inactive state to the active state at a first time (t1) either on a change of the first input signal (clock) of the circuit (SG) from the inactive state to the active state or during the active first input signal (clock) of the circuit (SG) in the event of a change of the second input signal (data valid) of the circuit (SG) from the inactive state to the active state, depending on which change has occurred most recently,
-   the circuit (SG) is designed such that the further output signal (data clock) from the circuit (SG) is switched from the inactive state to the active state at a second time (t2) in the event of a change of the first input signal (clock) of the circuit (SG) from the inactive state to the active state.

2.  Circuit for production of an output signal according to Claim 1, **characterized in that** the output signal (output clock) from the circuit (SG) is switched from the active state to the inactive state in the event of a change, which immediately follows the first time (t1), of the first input signal (clock) to the circuit (SG) from the active state to the inactive state.

3.  Circuit for production of an output signal according to Claim 1, **characterized in that** the output signal (output clock) from the circuit (SG) is switched from the active state to the inactive state in the event of a change, which immediately follows the first time (t1), of the first input signal (clock) to the circuit (SG) from the active state to the inactive state, or in the event of a change of the second input signal (data valid) to the circuit (SG) from the active state to the inactive state, depending on which change has occurred most recently.

EP 0 991 074 B1

**4.** Circuit for production of an output signal according to Claim 1, **characterized in that**
the output signal (output clock) from the circuit (SG) remains in the active state throughout a first fixed time period (T1), and then changes to the inactive state.

**5.** Circuit for controlling a data driver according to Claim 4, **characterized in that** the first fixed time period (T1) is at least as long as is required by the components which are connected to the connection for the output signal (output clock) from the circuit (SG) for reliable signal identification in the event of a state change of the output signal (output clock) from the circuit (SG).

**6.** Circuit for production of an output signal according to one of the preceding claims, **characterized in that**
the further output signal (data clock) from the circuit (SG) is switched from the active state to the inactive state in the event of a change, which immediately follows the second time (t2), of the first input signal (clock) of the circuit (SG) from the active state to the inactive state, or in the event of a change of the second input signal (data valid) to the circuit (SG) from the active state to the inactive state, depending on which change has occurred most recently.

**7.** Circuit for production of an output signal according to one of Claims 1 to 5, **characterized in that**
the further output signal (data clock) from the circuit (SG) remains in the active state throughout a second fixed time period (T2), and then changes to the inactive state.

**8.** Circuit for production of an output signal according to Claim 7, **characterized in that** the second fixed time period (T2), calculated from the time from which the second input signal (data valid) to the circuit (SG) changes to the active state, is at least as long as is required by the components which are connected to the connection for the further output signal (data clock) from the circuit (SG) for reliable signal identification in the event of a state change of the further output signal (data clock) from the circuit (SG).

**9.** Circuit for production of an output signal according to Claim 2, **characterized by** the following features:

- the circuit (SG) has a second memory device (SRFF2) whose first input (S2) is connected to the first input signal (clock) to the circuit (SG), and whose second input (R2) is connected via an inverter to the second input signal (data valid) to the circuit (SG),
- the second memory device (SRFF2) itself has a connection for an output signal (Q2) which assumes active and inactive states,
- the output signal (Q2) from the second memory device (SRFF2) is delayed in time and is passed to a second connection (R1) of the first memory device (SRFF1), logically linked with the inverted first input signal ($\overline{\text{clock}}$) to the circuit (SG),
- the output signal (Q1) from the first memory device (SRFF1) is logically linked with the first input signal (clock) to the circuit (SG), thus resulting in the output signal (output clock) from the circuit (SG).

**10.** Circuit for production of an output signal according to Claim 3, **characterized by** the following features:

- the circuit (SG) has a third memory device (SRFF3) whose first input (S3) is connected to a signal (s3) which is obtained from logical linking of the first input signal (clock) to the circuit (SG) and the output signal (Q1) from the first memory device (SRFF1), and whose second input (R3) is connected via an inverter to the second input signal (data valid) to the circuit (SG),
- the third memory device (SRFF3) itself has a connection for an output signal (Q3) which assumes active and inactive states and forms the output signal (output clock) from the circuit (SG),
- the output signal (Q3) from the third memory device (SRFF3) is delayed in time and is passed to a second input (R1) of the first memory device (SRFF1), logically linked to the inverted first input signal ($\overline{\text{clock}}$) to the circuit (SG).

**11.** Circuit for production of an output signal according to Claim 4, **characterized by** the following features:

- the circuit (SG) has a second memory device (SRFF2) whose first input (S2) is connected to the first input signal (clock) to the circuit (SG) and whose second input (R2) is connected via an inverter to the second input signal (data valid) to the circuit (SG),
- the second memory device (SRFF2) itself has a connection for an output signal (Q2) which assumes active and inactive states,
- the output signal (Q2) from the second memory device (SRFF2) is delayed in time and is passed to a second connection (R1) of the first memory device (SRFF1), logically linked to the inverted first input signal ($\overline{clock}$) to the circuit (SG),

- the output signal (Q1) from the first memory device (SRFF1) is logically linked with the first input signal (clock) to the circuit (SG),
- the circuit (SG) has a third memory device (SRFF3) whose first input (S3) is connected to a signal (s3) which is obtained from the logical linking of the first input signal (clock) to the circuit (SG) and the output signal (Q1) from the first memory device (SRFF1),
- the third memory device (SRFF3) itself has a connection for an output signal (Q3) which assumes active and inactive states and forms the output signal (output clock) from the circuit (SG),
- the output signal (Q3) from the third memory device (SRFF3) is delayed in time and is passed to a second input (R3) of the third memory device (SRFF3).

12. Circuit for production of an output signal according to Claim 6, **characterized by** the following features:

- the circuit (SG) has a fourth memory device (SRFF4) whose first input (S4) is connected to a signal (s4) which is obtained from logical linking of the first input signal (clock) to the circuit (SG) and of the second input signal (data valid) to the circuit (SG), and whose second input (R4) is connected via an inverter to the second input signal (data valid) to the circuit (SG),
- the fourth memory device (SRFF4) itself has a connection for an output signal (Q4) which assumes active and inactive states,
- the further output signal (data clock) from the circuit (SG) is obtained from logical linking of the first input signal (clock) to the circuit (SG) and the output signal (Q4) from the fourth memory device (SRFF4).

13. Circuit for production of an output signal according to Claim 7, **characterized by** the following features:

- the circuit (SG) has a fourth memory device (SRFF4) whose first input (S4) is connected to a signal (s4) which is obtained from logical linking of the first input signal (clock) to the circuit (SG) and of the second input signal (data valid) to the circuit (SG),
- the fourth memory device (SRFF4) itself has a connection for an output signal (Q4) which assumes active and inactive states,
- a second input (R4) to the fourth memory device (SRFF4) is connected to the time-delayed output signal (Q4) from the fourth memory device (SRFF4),
- the further output signal (data clock) from the circuit (SG) is obtained from logical linking of the first input signal (clock) to the circuit (SG) and the output signal (Q4) from the fourth memory device (SRFF4).

**Revendications**

1. Circuit de production d'un signal de sortie en fonction de deux signaux d'entrée, lequel circuit a les particularités suivantes :

- le circuit (SG) comporte deux bornes destinées à deux signaux d'entrée (clock, data valid) qui ont chacun des états actif et inactif, et un signal de sortie (output clock) qui en est dérivé et a des états actif et inactif ;
- le circuit (SG) comporte une borne destinée à un signal de sortie supplémentaire (data clock) qui prend des états actif et inactif ;
- la borne destinée au deuxième signal d'entrée (data valid) du circuit (SG) est reliée à une première entrée (S1) d'un premier dispositif de mémoire (SRFF1) ;
- le premier dispositif de mémoire (SRFF1) comporte, quant à lui, une borne destinée à un signal de sortie (Q1) qui prend des états actif et inactif ;
- le premier dispositif de mémoire (SRFF1) est constitué de telle manière que le signal de sortie (Q1) du premier dispositif de mémoire (SRFF1) présente un état actif dès qu'un signal actif est appliqué au niveau de la première entrée (S1) du premier dispositif de mémoire (SRFF1) ;
- le circuit (SG) est réalisé de telle manière que, lorsque le signal de sortie (Q1) du premier dispositif de mémoire (SRFF1) est actif, le signal de sortie (output clock) du circuit (SG) est commuté, à un premier instant (t1), de l'état inactif à l'état actif, soit lors d'un passage du premier signal d'entrée (clock) du circuit (SG) de l'état inactif à l'état actif, soit pendant que le premier signal d'entrée (clock) du circuit (SG) est actif, lors d'un passage du deuxième signal d'entrée (data valid) du circuit (SG) de l'état inactif à l'état actif, et ce, en fonction de celui des deux passages qui survient temporellement en dernier ;

- le circuit (SG) est réalisé de telle manière que le signal de sortie supplémentaire (data clock) du circuit (SG) est commuté, à un deuxième instant (t2), de l'état inactif à l'état actif lors d'un passage du premier signal d'entrée (clock) du circuit (SG) de l'état inactif à l'état actif.

2. Circuit de production d'un signal de sortie selon la revendication 1, **caractérisé en ce que** le signal de sortie (output clock) du circuit (SG) est commuté de l'état actif à l'état inactif lors d'un passage du premier signal d'entrée (clock) du circuit (SG) de l'état actif à l'état inactif juste après le premier instant (t1).

3. Circuit de production d'un signal de sortie selon la revendication 1, **caractérisé en ce que** le signal de sortie (output clock) du circuit (SG) est commuté de l'état actif à l'état inactif lors du passage du premier signal d'entrée (clock) du circuit (SG) de l'état actif à l'état inactif juste après le premier instant (t1) ou lors du passage du deuxième signal d'entrée (data valid) du circuit (SG) de l'état actif à l'état inactif, et ce, en fonction de celui des deux passages qui survient temporellement en dernier.

4. Circuit de production d'un signal de sortie selon la revendication 1, **caractérisé en ce que** le signal de sortie (output clock) du circuit (SG) reste dans l'état actif pendant un premier laps de temps fixe (T1) et passe ensuite à l'état inactif.

5. Circuit de commande d'un pilote de données selon la revendication 4, **caractérisé en ce que** le premier laps de temps fixe (T1) est au moins aussi long que ce qu'il faut aux composants qui sont raccordés à la borne destinée au signal de sortie (output clock) du circuit (SG) pour effectuer une reconnaissance de signal fiable lors d'un changement d'état du signal de sortie (output clock) du circuit (SG).

6. Circuit de production d'un signal de sortie selon l'une des revendications précédentes, **caractérisé en ce que** le signal de sortie supplémentaire (data clock) du circuit (SG) est commuté de l'état actif à l'état inactif lors d'un passage du premier signal d'entrée (clock) du circuit (SG) de l'état actif à l'état inactif juste après le deuxième instant (t2) ou lors du passage du deuxième signal d'entrée (data valid) du circuit (SG) de l'état actif à l'état inactif, et ce, en fonction de celui des deux passages qui survient temporellement en dernier.

7. Circuit de production d'un signal de sortie selon l'une des revendications 1 à 5, **caractérisé en ce que** le signal de sortie supplémentaire (data clock) du circuit (SG) reste dans l'état actif pendant un deuxième laps de temps fixe (T2) et passe ensuite à l'état inactif.

8. Circuit de production d'un signal de sortie selon la revendication 7, **caractérisé en ce que** le deuxième laps de temps fixe (T2), calculé depuis l'instant à partir duquel le deuxième signal d'entrée (data valid) du circuit (SG) passe à l'état actif, est au moins aussi long que ce qu'il faut aux composants qui sont raccordés à la borne destinée au signal de sortie supplémentaire (data clock) du circuit (SG) pour effectuer une reconnaissance de signal fiable lors d'un changement d'état du signal de sortie supplémentaire (data clock) du circuit (SG).

9. Circuit de production d'un signal de sortie selon la revendication 2, **caractérisé par** les particularités suivantes :

   - le circuit (SG) comporte un deuxième dispositif de mémoire (SRFF2) dont la première entrée (S2) est reliée au premier signal d'entrée (clock) du circuit (SG) et dont la deuxième entrée (R2) est reliée au deuxième signal d'entrée (data valid) du circuit (SG) par l'intermédiaire d'un inverseur ;
   - le deuxième dispositif de mémoire (SRFF2) comporte, quant à lui, une borne destinée à un signal de sortie (Q2) qui prend des états actif et inactif ;
   - le signal de sortie (Q2) du deuxième dispositif de mémoire (SRFF2) est commuté vers une deuxième borne (R1) du premier dispositif de mémoire (SRFF1) en étant retardé temporellement et en étant combiné logiquement au premier signal d'entrée inversé ($\overline{clock}$) du circuit (SG) ;
   - le signal de sortie (Q1) du premier dispositif de mémoire (SRFF1) est combiné logiquement au premier signal d'entrée (clock) du circuit (SG), ce qui donne le signal de sortie (output clock) du circuit (SG).

10. Circuit de production d'un signal de sortie selon la revendication 3, **caractérisé par** les particularités suivantes :

   - le circuit (SG) comporte un troisième dispositif de mémoire (SRFF3) dont la première entrée (S3) est reliée à un signal (s3) qui résulte d'une combinaison logique du premier signal d'entrée (clock) du circuit (SG) et du signal de sortie (Q1) du premier dispositif de mémoire (SRFF1), et dont la deuxième entrée (R3) est reliée au deuxième signal d'entrée (data valid) du circuit (SG) par l'intermédiaire d'un inverseur ;

- le troisième dispositif de mémoire (SRFF3) comporte, quant à lui, une borne destinée à un signal de sortie (Q3) qui prend des états actif et inactif et forme le signal de sortie (output clock) du circuit (SG) ;
- le signal de sortie (Q3) du troisième dispositif de mémoire (SRFF3) est commuté vers une deuxième entrée (R1) du premier dispositif de mémoire (SRFF1) en étant retardé temporellement et en étant combiné logiquement au premier signal d'entrée inversé ($\overline{\text{clock}}$) du circuit (SG).

**11.** Circuit de production d'un signal de sortie selon la revendication 4, **caractérisé par** les particularités suivantes :

- le circuit (SG) comporte un deuxième dispositif de mémoire (SRFF2) dont la première entrée (S2) est reliée au premier signal d'entrée (clock) du circuit (SG) et dont la deuxième entrée (R2) est reliée au deuxième signal d'entrée (data valid) du circuit (SG) par l'intermédiaire d'un inverseur ;
- le deuxième dispositif de mémoire (SRFF2) comporte, quant à lui, une borne destinée à un signal de sortie (Q2) qui prend des états actif et inactif ;
- le signal de sortie (Q2) du deuxième dispositif de mémoire (SRFF2) est commuté vers une deuxième borne (R1) du premier dispositif de mémoire (SRFF1) en étant retardé temporellement et en étant combiné logiquement au premier signal d'entrée inversé ($\overline{\text{clock}}$) du circuit (SG) ;
- le signal de sortie (Q1) du premier dispositif de mémoire (SRFF1) est combiné logiquement au premier signal d'entrée (clock) du circuit (SG) ;
- le circuit (SG) comporte un troisième dispositif de mémoire (SRFF3) dont la première entrée (S3) est reliée à un signal (s3) qui résulte de la combinaison logique du premier signal d'entrée (clock) du circuit (SG) et du signal de sortie (Q1) du premier dispositif de mémoire (SRFF1) ;
- le troisième dispositif de mémoire (SRFF3) comporte, quant à lui, une borne destinée à un signal de sortie (Q3) qui prend des états actif et inactif et forme le signal de sortie (output clock) du circuit (SG) ;
- le signal de sortie (Q3) du troisième dispositif de mémoire (SRFF3) est commuté vers une deuxième entrée (R3) du troisième dispositif de mémoire (SRFF3) en étant retardé temporellement.

**12.** Circuit de production d'un signal de sortie selon la revendication 6, **caractérisé par** les particularités suivantes :

- le circuit (SG) comporte un quatrième dispositif de mémoire (SRFF4) dont la première entrée (S4) est reliée à un signal (s4) qui résulte d'une combinaison logique du premier signal d'entrée (clock) du circuit (SG) et du deuxième signal d'entrée (data valid) du circuit (SG), et dont la deuxième entrée (R4) est reliée au deuxième signal d'entrée (data valid) du circuit (SG) par l'intermédiaire d'un inverseur ;
- le quatrième dispositif de mémoire (SRFF4) comporte, quant à lui, une borne destinée à un signal de sortie (Q4) qui prend des états actif et inactif ;
- le signal de sortie supplémentaire (data clock) du circuit (SG) résulte d'une combinaison logique du premier signal d'entrée (clock) du circuit (SG) avec le signal de sortie (Q4) du quatrième dispositif de mémoire (SRFF4).

**13.** Circuit de production d'un signal de sortie selon la revendication 7, **caractérisé par** les particularités suivantes :

- le circuit (SG) comporte un quatrième dispositif de mémoire (SRFF4) dont la première entrée (S4) est reliée à un signal (s4) qui résulte d'une combinaison logique du premier signal d'entrée (clock) du circuit (SG) et du deuxième signal d'entrée (data valid) du circuit (SG) ;
- le quatrième dispositif de mémoire (SRFF4) comporte, quant à lui, une borne destinée à un signal de sortie (Q4) qui prend des états actif et inactif ;
- une deuxième entrée (R4) du quatrième dispositif de mémoire (SRFF4) est reliée au signal de sortie retardé temporellement (Q4) du quatrième dispositif de mémoire (SRFF4) ;
- le signal de sortie supplémentaire (data clock) du circuit (SG) résulte d'une combinaison logique du premier signal d'entrée (clock) du circuit (SG) avec le signal de sortie (Q4) du quatrième dispositif de mémoire (SRFF4).

## FIG 1

FIG 2

FIG 3

EP 0 991 074 B1

FIG 4

EP 0 991 074 B1

## FIG 5

CLOCK

DATA VALID

DATA CLOCK

$t_a$    $t_2$

## FIG 6

CLOCK

DATA VALID

DATA CLOCK

$t_a$    T2

## FIG 7

| DFF2 | | |
|---|---|---|
| D | CLK | Q |
| X | 0 | Q -1 |
| D | 1 | D |

| DFF1 | | |
|---|---|---|
| D | CLK | Q |
| X | 0 | Q -1 |
| D | ↗ | D |
| X | 1 | unverändert |

## FIG 8

## FIG 9

FIG 10

OUTPUT_CLOCK

SG

CLOCK

DATA_VALID

AND

S1  Q1
SRFF1
R1

$\overline{CLOCK}$
AND
delay
INV

S2  Q2
SRFF2
R2

INV

| SR Flip | | Flop (SRFF) | |
|---|---|---|---|
| S | R | Q | Q-1 |
| Ø | Ø | Q | Q-1 |
| 1 | Ø | 1 | 1 |
| Ø | 1 | Ø | Ø |
| 1 | 1 | 1 | 1 |

# FIG 11

| SR | Flip | Flop (SRFF) |
|----|------|-------------|
| S  | R    | Q           |
| Ø  | Ø    | Q -1        |
| 1  | Ø    | 1           |
| Ø  | 1    | Ø           |
| 1  | 1    | 1           |

EP 0 991 074 B1

## FIG 12

| SR | Flip | Flop (SRFF) |
|---|---|---|
| S | R | Q |
| Ø | Ø | Q -1 |
| 1 | Ø | 1 |
| Ø | 1 | Ø |
| 1 | 1 | 1 |

EP 0 991 074 B1

# FIG 13

| SR | Flip | Flop (SRFF) |
| --- | --- | --- |
| S | R | Q |
| Ø | Ø | Q -1 |
| 1 | Ø | 1 |
| Ø | 1 | Ø |
| 1 | 1 | 1 |

EP 0 991 074 B1

# FIG 14

**CLOCK** ■→     → OUTPUT_CLOCK

    → DATA_CLOCK

s4

| AND | S4    Q4 |
| SRFF4 |

delay — R4

SG

OR

**DATA_VALID** ■→

| SR | Flip | Flop (SRFF) |
|----|------|-------------|
| S | R | Q |
| $\emptyset$ | $\emptyset$ | Q -1 |
| 1 | $\emptyset$ | 1 |
| $\emptyset$ | 1 | $\emptyset$ |
| 1 | 1 | 1 |

EP 0 991 074 B1